# EUROPEAN PATENT APPLICATION

(11) **EP 2 648 225 A1**
(43) Date of publication of application: **09.10.2013**
(21) Application number: 11844340.7
(22) Date of filing: 24.11.2011
(51) Int. Cl.: H01L 31/042

(54) **SOLAR CELL MODULE**

(30) Priority: 30.11.2010 JP 2010267487
(71) Applicant: Sanyo Electric Co., Ltd., Osaka 570-8677 (JP)
(72) Inventor: YOSHIMINE Yukihiro, Moriguchi-shi Osaka 570-8677 (JP); MATSUNE Kengo, Moriguchi-shi Osaka 570-8677 (JP)
(74) Representative: Glawe, Delfs, Moll
(86) International application number: PCT/JP2011/076979
(87) International publication number: WO 2012/073771

(57) **Abstract**

[Problem] To provide a solar cell module that suppresses cell cracks.

[Solution] A solar cell module (13) is constituted to include a plurality of solar cells (2), which have one main surface side electrode (4) and another main surface side electrode ( 6), and conductive contact members (1) electrically connecting the one main surface side electrode (4) or the other main surface side electrode (6) of one solar cell (2) and the one main surface side electrode (4) or the other main surface side electrode (6) of another solar cell (2). The conductive contact members (1) have a first main surface having at least one protruding part (la) and a second main surface having a flat surface (1 b) on the side opposite the first main surface. The first main surface is affixed to the other main surface side electrode by an adhesive (12) formed from a resin, and the second main surface is affixed to the one main surface side electrode (4) by the adhesive (12) formed from a resin.

## Description

### FIELD OF THE INVENTION

The present invention relates to a solar cell module.

### BACKGROUND

Generally, solar cell modules are configured by electrically connecting a plurality of solar cells in series and/or parallel.

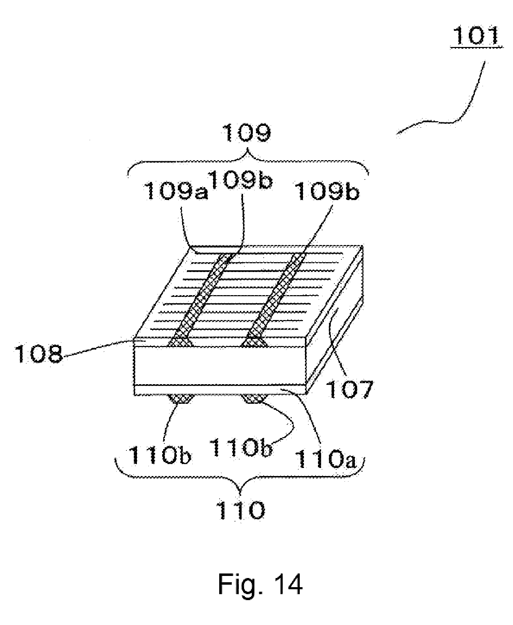

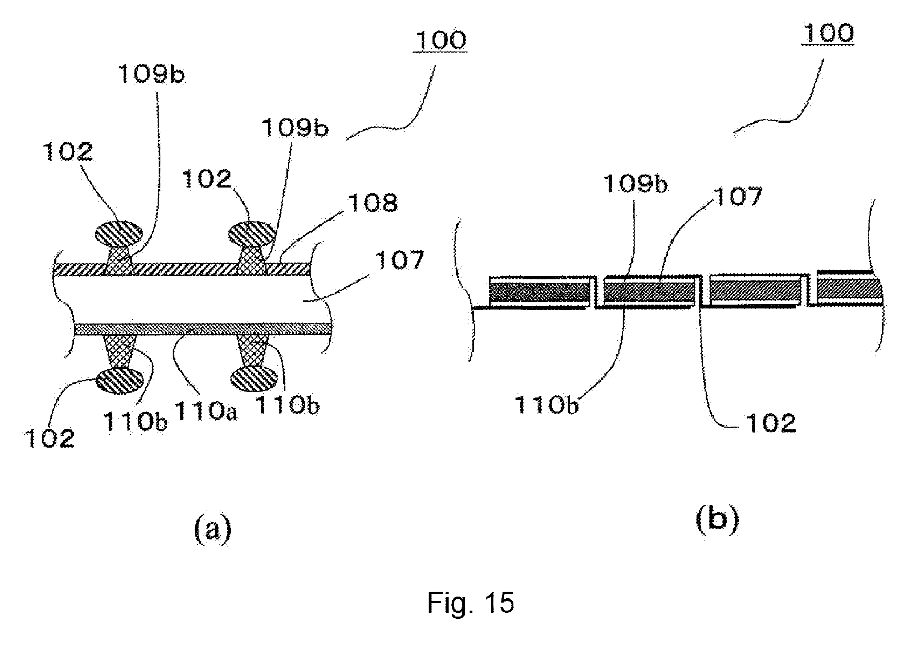

FIG. 14 is a perspective view of a solar cell 101, FIG. 15A is a cross-section view for describing a connection between the solar cell 101 and a conductive connecting member 102, and FIG. 15B is a cross-section view for describing a connection between the solar cell 101 and the conductive connecting member 102 in a solar cell module 100.

In the figures, the solar cell 101 contains a semiconductor substrate 107 with a pn junction, a reflection preventing film 108 and a front side electrode 109 formed on the front surface of the semiconductor substrate 107, and a back surface side electrode 110 formed on the back surface of the semiconductor substrate 107.

The front surface side electrode 109 includes a plurality of finger shaped collecting electrodes 109a and two busbar electrodes 109b orthogonal to the collecting electrodes 109a. The back surface side electrode 110 includes a metal film collecting electrode 110a and a busbar electrode 110b.

The busbar electrode 109b of one solar cell 101 and the BuSpar electrode 110b of an adjacent solar cell 101 are connected by the conductive connecting member 102.

### Prior Technology Documents

Patent document 1 Japanese Unexamined Patent Application 2009-54981

### SUMMARY

### PROBLEM TO BE RESOLVED BY THE INVENTION

Japanese Unexamined Patent Application 2009-54981 discloses a conductive connecting member covered by a substantially elliptical solder layer.

With this conductive connecting member, if the opposing positions of the conductive connecting member on the front surface side of the solar cell and the conductive connecting member on the back surface side shift during the process of connecting the conductive connecting member and the solar cell, an undesirable stress will occur in the solar cell, and there is a possibility that the solar cell will crack.

### MEANS FOR RESOLVING PROBLEMS

The solar cell module of the present invention contains a plurality of solar cells having a first main surface side electrode and a second main surface side electrode, and a conductive connecting member that electrically connects either the first main surface side electrode or the second main surface side electrode of a first solar cell, and the first main surface side electrode or second main surface side electrode of a second solar cell; wherein the conductive connecting member has a first main surface with at least one convex part and a second main surface with a flat surface opposing the first main surface; the first main surface is attached by adhesive containing resin to the second main surface side electrode; and the second main surface is attached by adhesive containing resin to the first main surface side electrode.

### EFFECT OF THE INVENTION

The present invention provides a solar cell module that suppresses cracking of the solar cells.

### BRIEF DESCRIPTION OF THE DRAWINGS

FIG. 1 illustrates the structure of the conductive connecting member according to the first embodiment of the present invention;
FIG. 2A is a front surface side surface view of the solar cell according to the first embodiment of the present invention, and FIG. 2B is a back surface side surface view of the solar cell according to the first embodiment the present invention;
FIG. 3 is a cross-section view along line A-A' in FIG. 2A and FIG. 2B;
FIG. 4 is a front surface side surface view for describing the connection between the solar cell and the conductive connecting member according to the first embodiment the present invention;
FIG. 5 is a cross-section view along line A-A' of FIG. 4A, and is a diagram illustrating the configuration of the connection between the conductive connecting member and the busbar electrode;
FIG. 6 is a cross-section view of the solar cell module according to the first embodiment of the present invention;
FIG. 7 illustrates the structure of the conductive connecting member according to the second embodiment of the present invention;
FIG. 8 is a cross-section view illustrating the configuration of the connection between the conductive connecting member and the busbar electrode according to the second embodiment of the present invention;
FIG. 9 illustrates the structure of the conductive connecting member according to the third embodiment of the present invention;
FIG. 10 is a cross-section view illustrating the configuration of the connection between the conductive connecting member and the busbar electrode according to the third embodiment of the present invention;
FIG. 11 is a partial cross-section view of the solar cell module according to an embodiment of the present invention;
FIG. 12 is a partial cross-section view of the solar cell module according to an embodiment of the present invention;
FIG. 13 is a front surface side surface view for describing the solar cell module according to an embodiment of the present invention;
FIG. 14 is a perspective view of a solar cell in a conventional solar cell module; and
FIG. 15A is a cross-section view for describing the connection between a conventional solar cell and the conductive connecting member, and FIG. 15B is a cross-section view for describing the connection between the solar cell and the conductive connecting member in a conventional solar cell module.

### DESCRIPTION OF THE PREFERRED EMBODIMENTS

### First embodiment

The solar cell module according to the first embodiment the present invention is described below in detail all referring to the drawings.

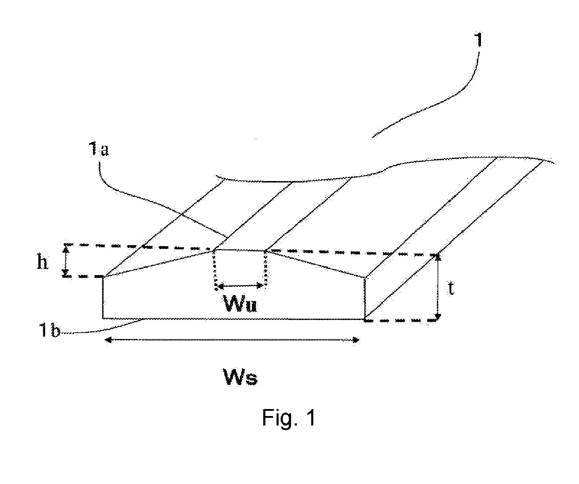

The conductive connecting member 1 for electrically connecting the solar cells of the solar cell module is described while referring to FIG. 1. FIG. 1 is a perspective view of the conductive connecting member 1.

The conductive connecting member 1 is made of a belt shaped copper wire or a silver wire with a hexagonal cross-section, the upper surface side has a convex part 1a with a trapezoidal cross-section in the short direction that extends like a stripe in the long direction, and the lower surface side has a flat surface 1b.

The conductive connecting member 1 has a width Ws of 1 mm, and a thickness t of 250 µm. The convex part 1a has an upper surface width Wu of 0.2 mm, smaller than the width Ws, and the height h is 50 µm. Note that the conductive connecting member 1 is coated with conductive layer such as Ag or a solder such as a Sn-Ag-Cu alloy and the like, so as to cover the area of the conductive connecting member 1 so that the entire lower surface is flat.

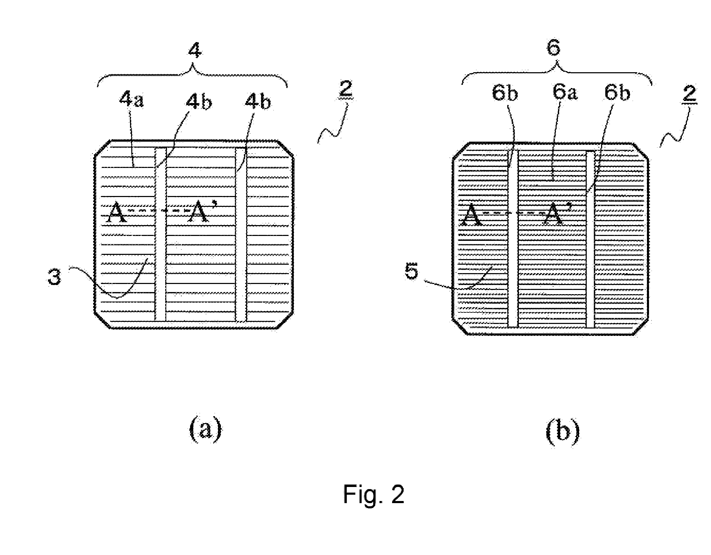

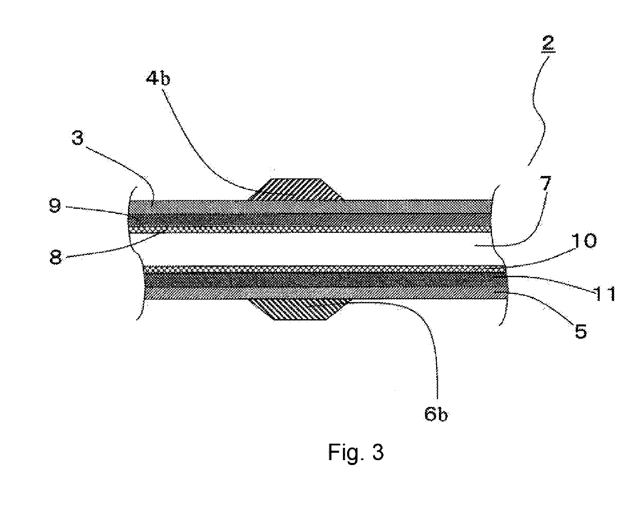

The solar cells that compose this solar cell module are described while referencing FIG. 2 and FIG. 3. FIG. 2A is a front surface side surface view of the solar cell 2, FIG. 2B is a back surface side surface view, and FIG. 3 is a cross-section view along line A-A' in FIG. 2.

In the figures, 2 represents a solar cell, where an i-type amorphous silicon layer 8 with a thickness of 5 nm to 20 nm, a p-type amorphous silicon layer 9 with a thickness of 5 nm to 20 nm, and a transparent electrode film layer 3 made of ITO or the like with a thickness of 70 µm to 100 nm are formed in order on the front surface of an n-type monocrystalline silicon substrate with a textured structure having a height of 5 to 10 µm. Furthermore, a front surface side electrode 4 is formed by hardening an Ag paste on the transparent electrode film layer 3.

Furthermore, an i-type amorphous silicon layer 10 with a thickness of 5 nm to 20 nm, a n-type amorphous silicon layer 11 with a thickness of 10 nm to 50 nm, and a transparent electrode film layer 5 made of ITO or the like with a thickness of 70 µm to 100 nm are formed in order on the back surface of an n-type monocrystalline silicon substrate 7with a textured structure having a height of 5 to 10 µm. Furthermore, a back surface side electrode 6 is formed by hardening an Ag paste on the transparent electrode film layer 5.

The n-type monocrystalline silicon substrate 7 is essentially a square with approximately 100 mm side for example, and the thickness is 100 µm to 300 µm.

Note that a configuration with reverse polarity to the solar cell 2 is acceptable, and in other words, a configuration where the n-type amorphous silicon layer is provided on the front surface side and the p-type amorphous silicon layer is provided on the back surface side is also acceptable.

The front surface side electrode 4 includes a plurality of finger electrodes 4a and two busbar electrodes 4b.

The plurality of finger electrodes 4a are formed across essentially the entire front surface of the transparent electrode film layer 3. The various finger electrodes 4a have a fine wire shape and are arranged to be mutually parallel. For example, the finger electrodes 4a have a thickness of 50 µm and a wire width of 50 µm, and are arranged with 2 mm intervals therebetween.

The two busbar electrodes 4b are integrally configured to be connected orthogonal to the plurality of finger electrodes 4a on the surface of the transparent electrode film layer 3. For example, the busbar electrode 4b has a linear shape with a thickness of 50 µm and a wire width of 200 µm. At this time, the wire width of the busbar electrode 4b is narrower than the lower surface width Ws of the conductive connecting member 1.

The back surface side electrode 6 includes a plurality of finger electrodes 6a and two busbar electrodes 6b.

With the present embodiment, the interval between adjacent finger electrodes 6a of the back surface side electrode 6 is formed to be narrower than the interval between adjacent finger electrodes 4a of the front surface side electrode 4.

The two busbar electrodes 6b are integrally configured to be connected to the plurality of finger electrodes 6a on the back surface of the transparent electrode film layer 5. For example, the busbar electrode 4b has a thickness of 50 µm and a line width of 200 µm. At this time, the wire width of the busbar electrode 6b is wider than the upper surface width Wu of the conductive connecting member 1.

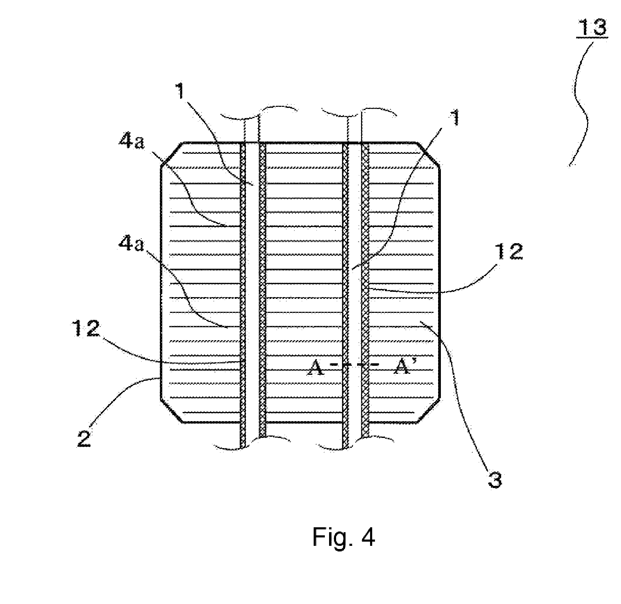

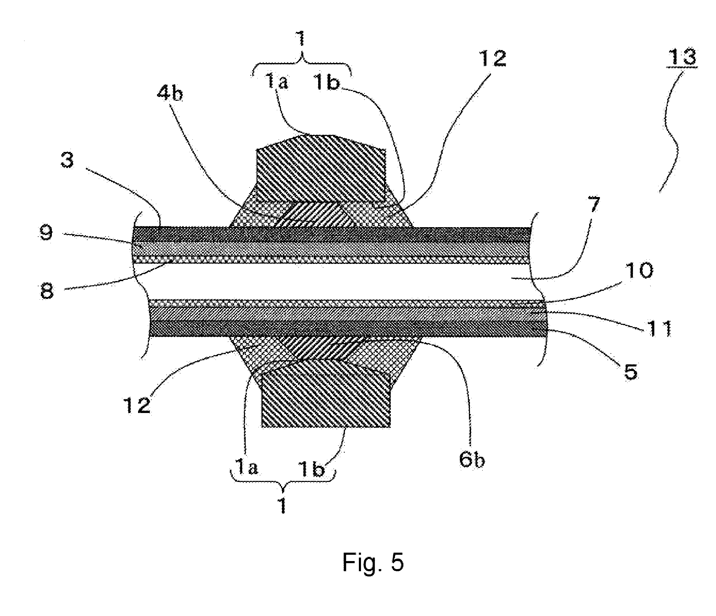

The connection between the solar cell 2 and the conductive connecting member 1 is described while referring to FIG. 4 and FIG. 5. FIG. 4 is a front surface side surface view for describing the connection between the solar cell 2 and the conductive connecting member 1, and FIG. 5 is a cross-section view along line A-A' in FIG. 4.

The busbar electrode 4b on the front surface side of one solar cell 2 is connected to the busbar electrode 6b on the back surface side of an adjacent solar cell 2 using an adhesive 12 containing a resin on each of the solar cells 2 in order to be electrically connected by the conductive connecting member 1.

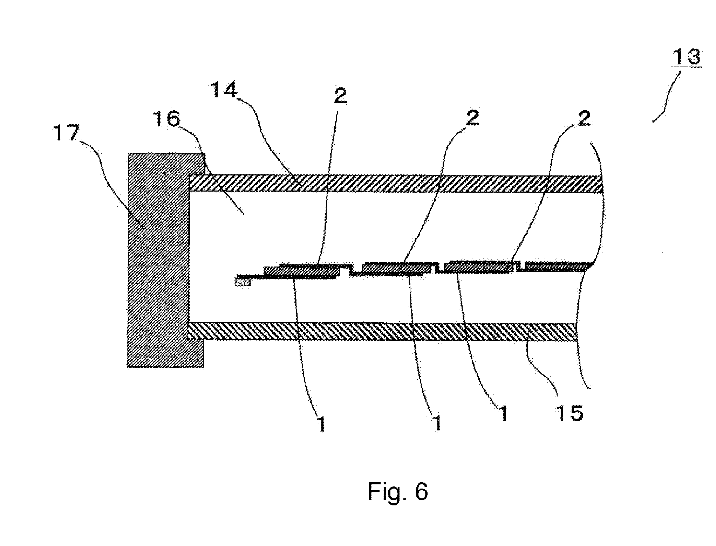

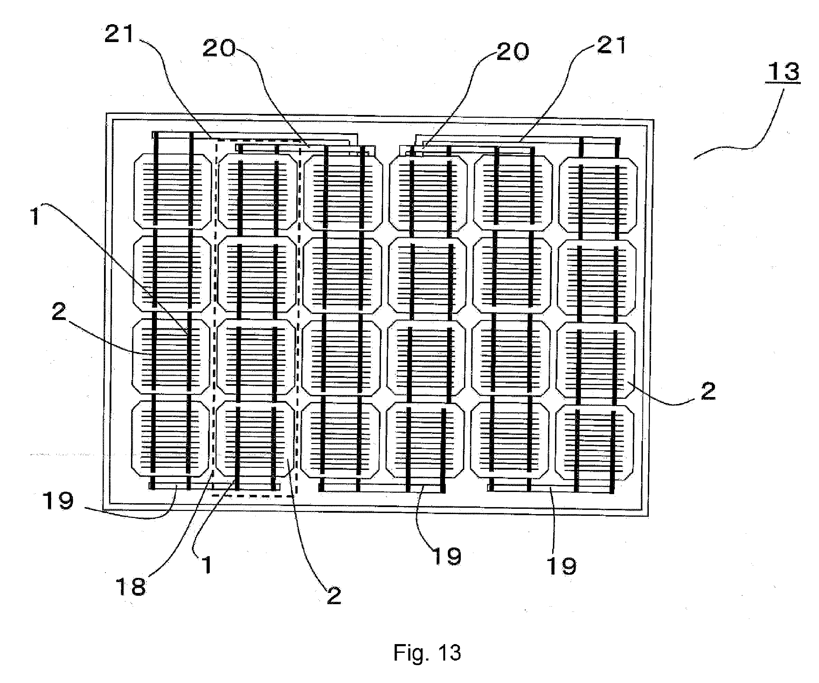

The solar cell module 13 of the first embodiment is described while referring to FIG. 6 and FIG. 13.

The solar cell module 13 contains a transparent front surface side cover 14 made of white plate reinforced glass or the like; a weather resistant back surface side cover 15 made from a resin film such as polyethylene terephthalate (PET) or the like; a plate shaped component body with a solar cell group 18 containing a plurality of solar cells 2 electrically connected in series by a conductive connecting member 1 arranged in a filler material 16 such as ethylene vinyl acetate (EVA) or the like between the front surface side cover 14 and the back surface side cover 15; and a metal frame 17 made of aluminum or the like that supports the component bodies.

The solar cell module 13 contains a solar cell group 18 where a plurality of solar cells 2 are connected in series by the conductive connecting member 1. The solar cell group 18 is connected to an adjacent solar cell group 18 by connecting members 19, 20.

The outermost solar cell group 18 is electrically connected to an L-shaped connecting member (connecting member for receiving output) 21 for receiving electrical output from the solar cell module 13. In this manner, the solar cell 2 is electrically connected to other solar cells 2 by the conductive connecting member 1.

The solar cell module 13 illustrated in FIG. 13 is completed by the foregoing process. Solar Cell Module Manufacturing Method

The manufacturing method of the solar cell module of the present embodiment is described. Herein, as an example, a method is described where the front surface side electrode 4 and the back surface side electrode 6 are manufactured using a silver paste where silver fine powder was kneaded into a resin such as an epoxy resin.

First, a solar cell 2 is prepared with a transparent electrode film layer 3, 5 on both surfaces.

Next, conductive paste is printed by screenprinting onto the transparent electrode film layer3 on the front surface side of the solar cell 2, and after drying for 10 minutes at 150°C, conductive paste is printed by screenprinting or offset printing onto the transparent electrode film layer 3 [Translator's note: Probably should be film layer 5] on the back surface side of the solar cell. Next, drying is performed for 1 hour at 200°C in order to completely harden the paste to form the front surface side electrode 4 and the back surface side electrode 6.

A plurality of solar cells 2 manufactured as described above are prepared along with a plurality of conductive connecting members 1.

Next, an adhesive 12 is provided between the flat part 1b of the lower surface side of each conductive connecting member 1 and the part facing the busbar electrode 4b, and between the convex part 1a of the upper surface side of the conductive connecting member 1 and the part that faces the BuSpar electrode 6b. For example, the adhesive 12 is an epoxy type thermoset resin that hard as when heated to approximately 200°C. For example, the adhesive 12 can be in the form of a film.

The adhesive 12 is provided on the busbar electrode 4b on the first solar cell 2 of the adjacent solar cells 2 and on the busbar electrode 6b of the second solar cell 2, a pressure of approximately 2 MPa is applied while heating for 30 seconds at 200°C with the conductive connecting member 1 positioned on each of these adhesives 12.

Next, a structural body is manufactured by preparing a plurality of solar cell group 18, and attaching to the outermost solar cell group 18 an L-shaped connecting member (connecting member for receiving output) 21 for receiving electrical output from the solar cell module 13. Next, the front surface side cover 14, sealing sheet that forms the filler material 16, structural body, sealing sheet that forms the filler 16, and the back surface side cover 15 R overlaid in order, and thermocompression bonded for 10 minutes at 150°C in a vacuum. Next, the filler material 16 is completely hardened by heating for 1 hour at 150°C.

Finally, a terminal box and metal frame are attached to complete the solar cell module 13.

The solar cell module 13 of the present embodiment has a stripe shaped convex part 1a on the upper surface side of the conductive connecting member 1, and a flat surface 1b on the lower surface side. Therefore, the busbar electrode 4b on the front surface side of the solar cell 2 is connected to the flat surface 1b of the conductive connecting member 1, and the busbar electrode 6b on the back surface side of the solar cell is connected to the convex part 1a of the conductive connecting member 1. Therefore, even if shifting occurs between the connecting surface of the flat surface 1b of the busbar electrode 4b on the front surface side and the connecting surface of the convex part 1a of the busbar electrode 6b on the back surface side, the lower surface width Ws of the conductive connecting member 1 is wider than the upper surface width Wu, and therefore the flat surface 1b acts to disperse the stress on the convex part 1a that is applied in a first direction of the solar cell 2. As a result, shear stress in the solar cell can be suppressed, and cracking of the solar cell 2 can be suppressed.

Furthermore, with the solar cell module 13 of the present embodiment, a front surface side cover 14 made of a white plate reinforced glass or the like is used on the front surface side, and a weather resistant back surface side cover 15 made from a resin film such as polyethylene terephthalate (PET) and the like is used on the back surface side. With atypical solar cell module 13 of this configuration, a different level of stress is applied to the conductive connecting member 1 on the front surface side and the back surface side of the solar cell 2 by the materials that form the covers on the front surface side and the back surface side.

With this solar cell module 13 configuration, the stress applied on the conductive connecting member 1 is higher on the back surface side of the solar cell 2 then the front surface side because the back surface side cover 15 is made from a material that is more flexible than the front surface side cover. Therefore, the busbar electrode 6b and the convex part 1a of the conductive connecting member 1 on the back surface side are connected while embedded in the adhesive 12. Therefore, the contact area between the conductive connecting member 1 and the adhesive 12 is increased by embedding the convex part 1a in the adhesive 12. As a result, the back surface side of the solar cell 2 and the conductive connecting member 1 are firmly connected, and the conductive connecting member 1 on the back surface side can be suppressed from separating from the solar cell 2 when forming the solar cell module 13.

With the manufacturing method of the present embodiment, cracking of the solar cell 2 can be suppressed when manufacturing the solar cell module.

### Second embodiment

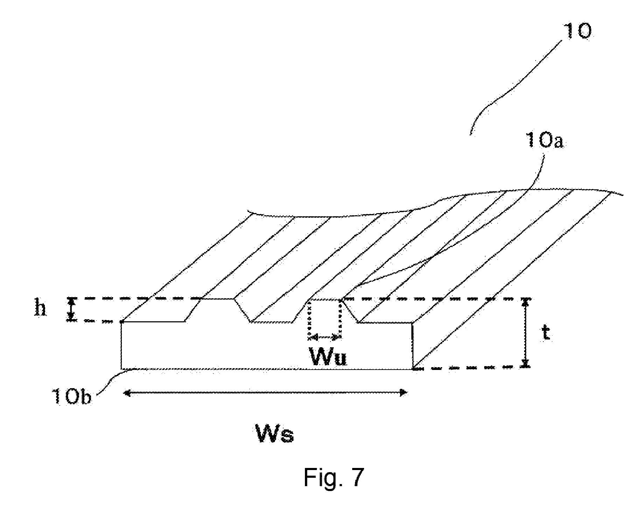

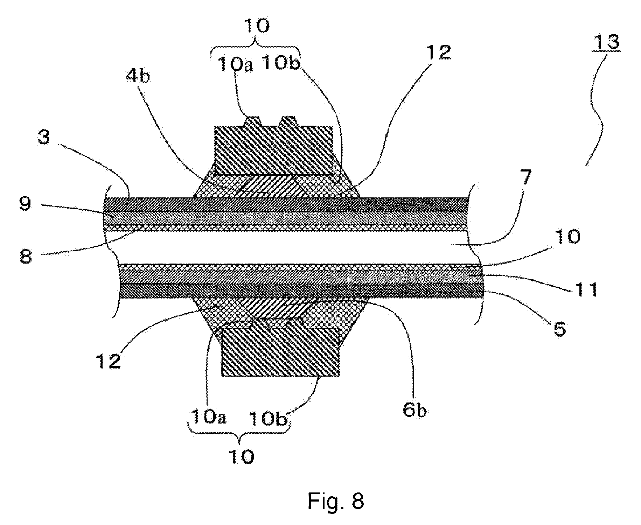

The solar cell module of the second embodiment of the present invention is described while referring to FIG. 7 and FIG. 8. FIG. 7 is a perspective view of the conductive connecting member 10 according to the second embodiment, and FIG. 8 is a diagram illustrating the connection form between the conductive connecting member 10 and the busbar electrodes 4b, 6b. Note that the differences to the first embodiment will primarily be described. Parts that are the same as the first embodiment are assigned the same code in FIG. 7 and FIG. 8, and a description thereof is omitted.

In reference to FIG. 7, the differences between the first embodiment and the second embodiment is that in the second embodiment, the conductive connecting member 10 has two convex parts 10a with a trapezoidal cross-section in the short direction and that extend mutually parallel in the form of a stripe in the long direction, on the upper surface side. The conductive connecting member 10 has a thickness t of 250 µm. The convex part 10a has an upper surface width Wu of 20 µm and a height h of 50 µm, and the flat surface 10b has a width Ws of 1 mm. The width of the sum of the upper surface widths of the two convex parts 10a is smaller than the width Ws of the flat surface 10b.

In reference to FIG. 8, with the present embodiment, the wire width of the busbar electrode 4b on the front surface side is narrower than the width Ws on the conductive connecting member 1. Furthermore, the upper surface width Wu of the conductive connecting member 10 is narrower than the wire with of the busbar electrode 6b on the back surface side.

With the present embodiment, the busbar electrode 4b on the front surface side of the solar cell 2 is connected to the flat surface 10b of the conductive connecting member 10, and the busbar electrode 6b on the back surface side of the solar cell is connected to the two stripe shaped convex parts 10a of the conductive connecting member 10. If the connecting surfaces of the connecting members on the front surface side and the back surface side of the solar cell 2 are shifted, the stress that was applied to the solar cell 2 that was a single stress because of the convex part 1a in the first embodiment is divided into two stresses by the two convex parts 10a, and the divided stress can further be dispersed by the flat surface 10b. As a result, shear stress in the solar cell 2 can be suppressed better than with the first embodiment, and cracking of the solar cell 2 can be suppressed.

When forming the solar cell module 13, the busbar electrode 6b and the two convex parts 10a of the conductive connecting member 10 on the back surface side are connected while embedded in the adhesive 12. Therefore, the contact area between the conductive connecting member 10 and the adhesive 12 can be larger than the first embodiment by embedding the two convex parts 10a in the adhesive 12. As a result, the back surface side of the solar cell 2 and the conductive connecting member 10 are firmly connected, and the conductive connecting member 1 on the back surface side can be better suppressed from separating from the solar cell 2 when forming the solar cell module 13, as compared to the first embodiment.

### Third embodiment

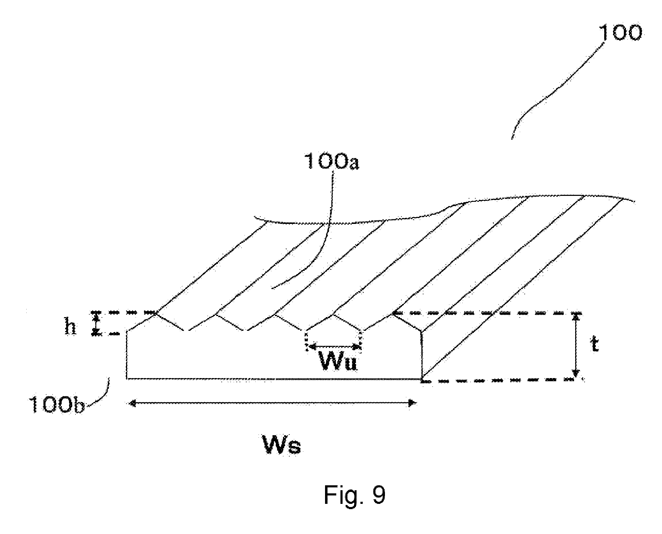

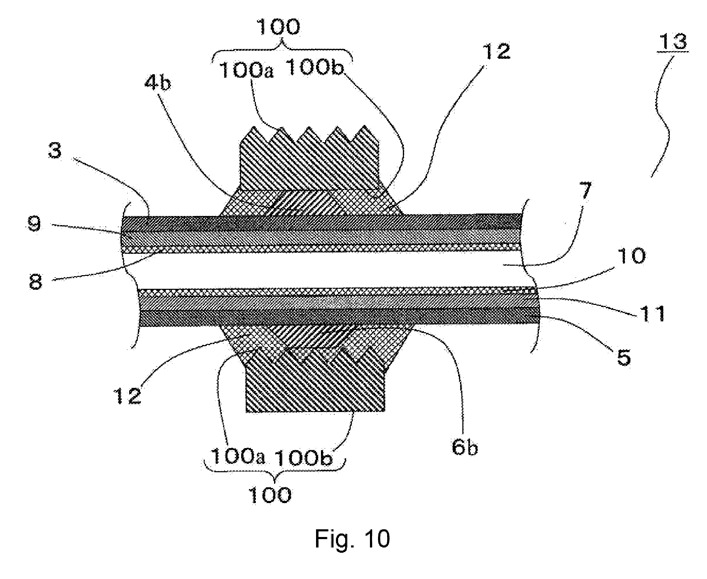

The solar cell module of the third embodiment of the present invention is described while referring to FIG. 9 and FIG. 10. FIG. 9 is a perspective view of the conductive connecting member 100 according to the third embodiment, and FIG. 10 is a diagram illustrating the connection form between the conductive connecting member 100 and the busbar electrodes 4b, 6b. Note that the differences to the second embodiment will primarily be described. Parts that are the same as the second embodiment are assigned the same code in FIG. 9 and FIG. 10, and a description thereof is omitted.

In reference to FIG. 9, the differences between the third embodiment and the second embodiment is that with the third embodiment, the conductive connecting member 100 has a plurality of convex parts with identical triangular cross-sections in the short direction periodically connected on the upper surface side, and a plurality of concave and convex parts 100a with a triangular shape that extend in parallel in the long direction.

For example, the conductive connecting member 100 is a copper wire with a thickness t of 230 µm. Furthermore, the conductive connecting member 100 has a bottom edge width Wu of the triangular concave and convex parts 100a of 30 µm, and the width Ws of the flat surface 100b is 1 mm.

Next, in reference to FIG. 10, with the present embodiment, the wire width of the busbar electrode 4b on the front surface side is narrower than the width Ws of the flat surface 100b on the conductive connecting member 1. Furthermore, the wire width of the busbar electrode 6b on the back surface side is narrower than the sum of the upper surface widths Wu of the conductive connecting member 1. Furthermore, the convex part on both ends of the conductive connecting member 100 has a configuration that is not exposed from the upper surface width Wu.

With the present embodiment, the busbar electrode 4b on the front surface side of the solar cell 2 is connected to the flat surface 100b of the conductive connecting member 100, and the busbar electrode 6b on the back surface side of the solar cell is connected to the plurality of triangular concave and convex parts 100a of the conductive connecting member 100. If the connecting surfaces of the connecting members on the front surface side and the back surface side of the solar cell 2 are shifted, the stress that was applied to the solar cell 2 that was divided into two stresses by the convex parts 10a, is further dispersed by the plurality of triangular concave and convex parts 100a, and the divided stress can further be dispersed by the flat surface 100b. As a result, shear stress in the solar cell 2 can be suppressed better than with the second embodiment, and cracking of the solar cell 2 can be suppressed.

When forming the solar cell module 13, the busbar electrode 6b and the plurality of triangular concave and convex parts 100a of the conductive connecting member 100 on the back surface side are connected while embedded in the adhesive 12. Therefore, the contact area between the conductive connecting member 100 and the adhesive 12 can be larger than the second embodiment by embedding the plurality of concave and convex parts 100a in the adhesive 12. As a result, the back surface side of the solar cell 2 and the conductive connecting member 100 are firmly connected, and the conductive connecting member 1 on the back surface side can be better suppressed from separating from the solar cell 2 when forming the solar cell module 13, as compared to the second embodiment.

Furthermore, with the present embodiment, of the light incident on the light receiving surface side, the light that reaches the plurality of triangular concave and convex parts 100a of the conductive connecting member 100 can be efficiently reflected. Therefore, more light will be re-reflected by the front surface side cover 14 illustrated in FIG. 6 or the filler material 16, and as a result, more light will enter the solar cell 2, and the output of the solar cell 2 will be enhanced.

Furthermore, with the present embodiment, the case where the busbar electrode on the front surface side of the solar cell and the busbar electrode on the back surface side of an adjacent solar cell are connected in series was described as an example, but the connection between adjacent solar cells is not restricted by the aforementioned embodiment.

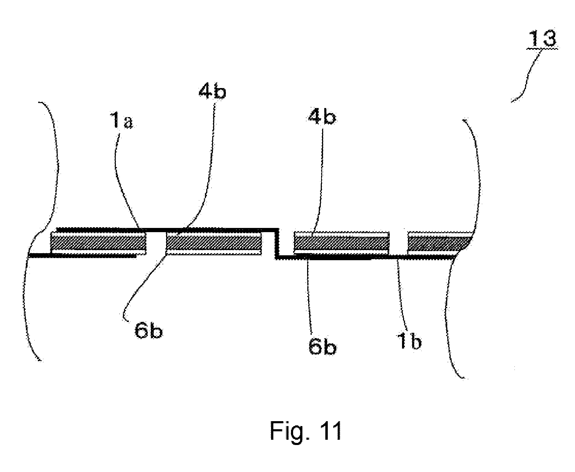

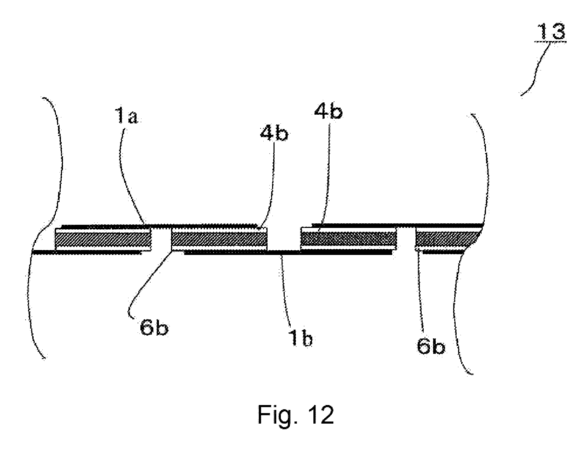

For example, the configurations of FIG. 11 and FIG. 12 are also possible. Note that in FIG. 11 and FIG. 12, parts that are identical or similar to the aforementioned embodiments are assigned the same code.

The solar cell module 13 illustrated in FIG. 11 is configured such that two adjacent solar cells 2 having an element construction with the same polarity are arranged in a set, two adjacent solar cells 2 having an element construction with reverse polarity to the aforementioned solar cells are arranged in a set, and these sets are electrically connected in series by a conductive connecting member 11.

With the solar cell module 13 illustrated in FIG. 12, the adjacent solar cells 2 have an element construction with mutually reversed polarity , and the conductive connecting members 1 electrically connect in series the front surface side electrodes of adjacent solar cell 2 and the back surface side electrodes of the solar cells 2. In this case, the lower surface of the conductive connecting member 1 with a flat surface and the front surface side electrode are connected, and the upper surface of the conductive connecting member 1 with at least one convex part is connected to the back surface side electrode.

The solar cell modules of these embodiments have a configuration with a flat surface on the bottom surface side of the conductive connecting member, but it is also possible for the flat surface to have concave and convex shapes with a thickness less than that of at least one convex part provided on the upper surface side of the conductive connecting member, preferably less than the height of the texture structure, for example 10 µm or less. In this case, cracking of the solar cells can be suppressed similar to the other embodiments.

Furthermore, the solar cell modules of the present invention can have a configuration with concave and convex shapes with a thickness less than that of at least one convex part provided on the upper surface side of the conductive connecting member, preferably less than the height of the texture structure, for example 10 µm or less, on the front surface side electrode and the back surface side electrode, similar to the flat surface on the lower surface side of the conductive connecting member. In this case, cracking of the solar cells can be suppressed similar to the other embodiments.

Furthermore, the solar cell module of the present invention is not restricted to the aforementioned embodiments, and for example a configuration without a frame is also possible.

Furthermore, the solar cell module of the present invention can be a double-sided light receiving solar cell module, and for example, both the front surface side cover and the back surface side cover can be glass plate.

Furthermore, an insulating adhesive can be used as the adhesive 12. Furthermore, the resin is not restricted to epoxy thermoset resins, and other resins can be appropriately used.

Furthermore, the adhesive 12 made from resin may also contain conductive particles such as Ni or Ag or the like, or may contain a non-conductive material such as non-conductive particles like SiO2 and the like, or may contain both of these types of particles, or neither type of particle.

The present invention is not restricted to the solar cell construction illustrated in FIG. 3, and can also be applied to various solar cells such as polycrystalline solar cells and the like.

Note that the aforementioned embodiments are presented in order to aid in understanding of the present invention, and should not be interpreted as restricting the present invention. The present invention can be altered and improved without violating the gist of the invention, and the present invention includes these alternatives.

### DESCRIPTION OF CODES

1, 10, 100 conductive connecting member
1a, 10a convex part
100a concave and convex part
1b, 10b, 100b flat surface
2 solar cell
4 front surface side electrode
4a finger electrode
4b busbar electrode
6 back surface side electrode
6a finger electrode
6b busbar electrode
13 solar cell module

## Claims

1. A solar cell module, comprising:
a plurality of solar cells having a first main surface side electrode and a second main surface side electrode, and
a conductive connecting member that electrically connects either the first main surface side electrode or the second main surface side electrode of a first solar cell, and the first main surface side electrode or second main surface side electrode of a second solar cell;
wherein the conductive connecting member has a first main surface with at least one convex part and a second main surface with a flat surface opposing the first main surface;
the first main surface is attached by adhesive containing resin to the second main surface side electrode; and
the second main surface is attached by adhesive containing resin to the first main surface side electrode.

2. The solar cell module according to claim 1, wherein an upper surface with of the convex part of the first main surface is smaller than a line width of the second main surface side electrode, and the width of the flat surface of the second main surface is larger than the line width of the second main surface side electrode.

3. The solar cell module according to claim 1 or 2, wherein at least one of the convex parts extends in the longitudinal direction of the conductive connecting member.

4. The solar cell module according to claim 3, wherein at least one of the convex parts contains a plurality of convex parts, and one or a plurality of convex parts are triangular convex parts where the cross-sections are periodically connected.

5. The solar cell module according to any one of claims 1 through 4, wherein the first main surface side electrode is on a light receiving surface side of the solar cell module, and the second main surface side electrode is on the opposite side as the light receiving surface side.

6. The solar cell module according to any one of claims 1 through 5, wherein the first main surface is oriented so as to face the opposite side as the light receiving surface side of the solar cell module, and the second main surface is oriented so as to face the light receiving surface side of the solar cell module.

7. The solar cell module according to any one of claims 1 through 6, wherein a front surface side cover is provided on the first main surface side, and a back surface side cover made of a material that is softer than the front surface side cover is provided on the second main surface side.
